(19) Europäisches Patentamt

European Patent Office

Office européen des brevets

(11) **EP 0 999 581 A2**

(12) **EUROPEAN PATENT APPLICATION**

(43) Date of publication:
**10.05.2000 Bulletin 2000/19**

(51) Int. Cl.$^7$: **H01L 21/22**, H01L 21/205

(21) Application number: **99120861.2**

(22) Date of filing: **26.10.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **02.11.1998 JP 31246298**

(71) Applicant: **NEC CORPORATION Tokyo (JP)**

(72) Inventors:
• **Kumashiro, Shigetaka**
  **Minato-ku, Tokyo (JP)**
• **Washio, Takumi**
  **Minato-ku, Tokyo (JP)**

(74) Representative:
**Baronetzky, Klaus, Dipl.-Ing. et al
Splanemann Reitzner
Baronetzky Westendorp
Patentanwälte
Rumfordstrasse 7
80469 München (DE)**

(54) **Simulation method executable with less time**

(57) In a simulation method, a matrix corresponding to equations defining physical and/or chemical phenomena is set in each of mesh regions. Preconditioning is executed to each of a plurality of small matrixes of a coefficient matrix of the matrix, and the preprocessing is determined based on influence of each of the equations to other mesh regions. Then, calculation is carried out to the matrix to determine a solution. Each of the equations is a diffusion and/or reaction equation, and each of the plurality of small matrix has a square matrix which has elements for the number of the equations in row and column directions. Also, the executing includes rearranging the coefficients for the equations which have terms influencing other mesh regions from an upper left portion of the small matrix, and the coefficients for the equations which have only terms not influencing the other meshes in a lower right portion of the small matrix.

Fig. 3

EP 0 999 581 A2

**Description**

**Background of the Invention**

1. Field of the Invention

The present invention relates to a simulation method, and more particularly, to a simulation method in which processing can be speeded up and a memory region can be reduced.

2. Description of the Related Art

Conventionally, a simulation of an impurity distribution in a semiconductor device manufacturing process is carried out based on a diffusion model using an equation (hereinafter, to be referred to as a "diffusion equation") describing impurity diffusion in a semiconductor substrate. As one example of the diffusion model, there is known the model described in "Impurity Doping Process in Silicon" by R. B. Fair (edited by F. F. Wang (North-Holland, Amsterdam), 1981, P. 315).

However, with a fine pattern structure of an LSI, a very shallow impurity introduction layer becomes necessary in recent years, and the study of the diffusion phenomenon of impurity ions in the semiconductor substrate has been made clear. According to the study, the diffusion phenomenon cannot be described by the above conventional diffusion model. For example, one phenomenon is as follows. That is, a lot of point-defects are produced in a semiconductor substrate with the impact of accelerated ions in an ion implantation process. The diffusion of the doped impurity ions is accelerated because of the point-defects in a thermal annealing process after the ion implantation.

According to the result of the conventional simulation method, the impurity distribution is hardly changed before and after the annealing process. In actual, however, the above impurity ion diffusion (hereinafter, to be referred to as "tail diffusion") is enhanced in the deeper region distanced about 0.4 $\mu$m or more from the substrate surface. Hereinafter, a base portion of the impurity concentration distribution is referred to as a "tail region".

In this way, the simulation using the conventional diffusion model cannot describe the tail diffusion, and an error in the impurity distribution after the annealing is large, especially, in the tail region. Therefore, there is a problem in the reliability of the simulation result.

Therefore, as the method of simulating the enhanced impurity ion diffusion in the above tail region is proposed a simulation method using a diffusion model in which reaction of the point-defect with the impurity ion in the silicon substrate is taken account for. Hereinafter, it is referred to as an "pair-diffusion model". For example, such a pair-diffusion model is described in "Dopant diffusion in silicon: A consistent view involving nonequilibrium defects" by D. Mathiot and J. C. Pfister (J. Appl. Phys. Vol.55, 1984, P. 3518). However, in this model, the calculating time is very long and it is difficult to realize a practical simulation.

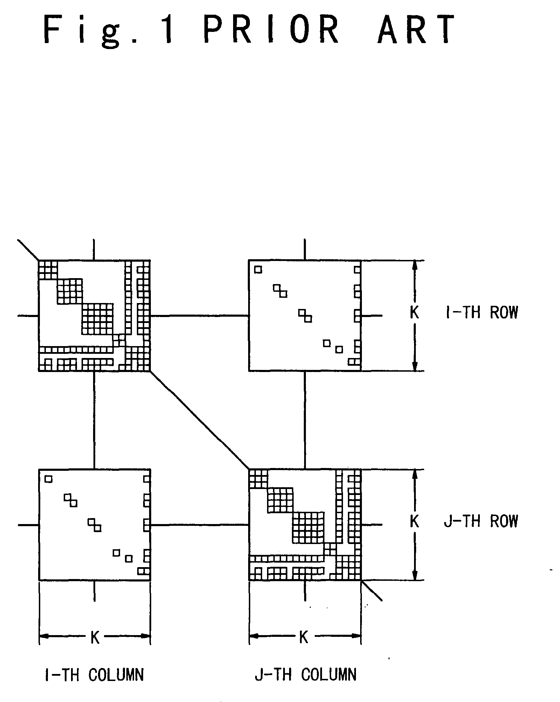

In a conventional method, as shown in Fig. 1, when the k (k is an integer more than 1) reaction and/or diffusion equation are defined in each of mesh points (i, j), a coefficient matrix has small matrixes of k $\times$ k elements. In this case, the order of the equations is not specified.

However, in the above-mentioned method, when inversion or transportation of a coefficient matrix is carried out for a matrix solving method using (in)complete LDU decomposition as pre-conditioning, even if non-diagonal element small matrix contains many elements of zero or approximate zero so as to be relatively sparse, the non-diagonal element small matrix is maintained as the small matrix of k $\times$ k and calculated in the same manner as a diagonal element small matrix which does not contain element of zero or approximate zero. For this reason, the above-mentioned method needs a lot of processing times and memory regions.

Because the calculating time becomes enormous in the anti-diffusion model which can describe the enhanced diffusion in the above tail region, the simulation with high reliability cannot be carried out in the short calculating time.

In conjunction with the above description, a diffusion simulation method is described in Japanese Laid Open Patent Application (JP-A-Heisei 10-64834). In this reference, when a portion of a semiconductor is oxidized into an oxide during a time interval, the portion is referred to as a transition, region. A fine impurity distribution in the transition region is calculated by solving a diffusion equation using diffusion coefficients peculiar to the transition region. Thus, a simulation can be provided without any restrictions to a movement distance of an interface between a silicon film and an oxide film and the size of mesh point.

Also, a simulation apparatus is described in Japanese Laid Open Patent Application (JP-A-Heisei 10-22231). In this reference, a processing section 103 executes a component dividing module 113, a diffusion parameter determining module 115 and an impurity concentration determining module 117 which are stored in a storage section 101, so that impurity to be simulated is divided into at least two components which are independent to each other. A diffusion equation is solved without changing a total quantity of the components, to determine a concentration distribution for every component. The impurity concentration distribution is determined by superimposing the concentration distributions for the components.

**Summary of the Invention**

Therefore, an object of the present invention is to provide a simulation method in which a calculating time can be reduced.

Another object of the present invention is to provide a simulation method in which a memory region to be used can be reduced.

Still another object of the present invention is to provide a computer-readable recording medium in which a program for any of the above simulation methods is stored.

In order to achieve an aspect of the present invention, a simulation method includes the steps of:

setting a matrix corresponding to equations defining physical and/or chemical phenomena in each of mesh regions;
executing preconditioning to each of a plurality of small matrixes in a coefficient matrix, the preconditioning being determined based on influence of each of the equations to other mesh regions; and
carrying out calculation to the matrix to determine a solution.

Here, each of the equations preferably is a diffusion and/or reaction equation. Also, it is preferable that each of the plurality of small matrix has a square matrix which has elements for the number of the equations in row and column directions. Also, the executing includes rearranging the coefficients for the equations which has terms influencing other mesh regions from an upper left portion of the small matrix, and the coefficients for the equations which has only terms not influencing the other meshes in a lower right portion of the small matrix.

Also, the executing may includes: rearranging coefficients of each of the plurality of small matrixes based on the influence of each of the equations to other mesh regions to produce rearranged small matrixes; and reducing the size of the rearranged small matrix when executing incomplete LDU decomposition. In this case, the coefficients for the equations which has terms influencing other mesh regions are rearranged from an upper left portion of the small matrix, and the coefficients for the equations which has only terms not influencing the other meshes are rearranged in a lower right portion of the small matrix. In addition, the simulation method may further include: determining whether the coefficient of a non-diagonal element of the small matrix is smaller than a predetermined value; and setting zero in place of the coefficient when it is determined that the coefficient of the non-diagonal element of the small matrix is smaller than a predetermined value.

In order to achieve another aspect of the present invention, a diffusion simulation method, includes: dividing a region into meshes; setting equations defining physical and/or chemical phenomena to each of the meshes; dividing the equations into a first group which has terms influencing other meshes and a second group which has only terms not influencing the other meshes; setting a matrix for getting a solution of the equations; dividing a coefficient matrix contained in the matrix into a plurality of small matrixes, wherein each of the plurality of small matrixes has a size determined based on the number of the equations; arranging in units of the meshes, coefficients of the equations, which belongs to the first group, in an upper left portion of a corresponding small matrix, and coefficients of the equations which belongs to the second group in a lower right portion of the corresponding the small matrix; carrying out calculation to each of the plurality of small matrixes to solve the equations; and outputting the solution of the equations to an output unit, wherein the calculation to the small matrixes as non-diagonal elements of the coefficient matrix is carried out to only the coefficients of the equations which belongs to the first group.

In this case, the small matrix may be a (k-th) order square matrix, when the number of the equations is k.

Also, the diffusion simulation method may further include: reducing the small matrixes as non-diagonal elements of the coefficient matrix to the small matrixes which consist of only the coefficients which are related with the equations which belongs to the first group.

The region is a semiconductor, and the equations are based on diffusion and/or chemical reaction of at least one of impurity ions, point-defects, holes, electrons, and pairs of the impurity ion and the point-defect in the semiconductor.

In order to achieve still another aspect of the present invention, a computer-readable recording medium which stores a program for a diffusion simulation method, includes: dividing a region into meshes; setting equations defining physical and/or chemical phenomena to each of the meshes; dividing the equations into a first group which has terms influencing other meshes and a second group which has only terms not influencing the other meshes; setting a matrix for getting a solution of the equations; dividing a coefficient matrix contained in the matrix into a plurality of small matrixes, wherein each of the plurality of small matrixes has a size determined based on the number of the equations; arranging in units of the meshes, coefficients of the equations, which belongs to the first group, in an upper left portion of a corresponding small matrix, and coefficients of the equations which belongs to the second group in a lower right portion of the corresponding the small matrix; carrying out calculation to each of the plurality of small matrixes to solve the equations; and outputting the solution of the equations to an output unit, wherein the calculation to the small matrixes as non-diagonal elements of the coefficient matrix is carried out to only the coefficients of the equations which belongs to the first group.

**Brief Description of the Drawings**

Fig. 1 is a diagram showing an arrangement of elements in a preconditioning matrix in a conventional example;
Fig. 2 is a functional block diagram showing the structure of a simulation apparatus according to an embodiment of the present invention;
Fig. 3 is a flow diagram showing an algorithm in the present invention;
Fig. 4 is a diagram showing an arrangement of elements in a preconditioning matrix in the present invention;
Fig. 5 is a diagram showing a 2-dimensional mesh points used in the simulation apparatus according to the embodiment of the present invention;
Fig. 6 is a diagram showing a control volume and a flux passage cross section when the 2-dimensional mesh points are used; and
Fig. 7 is a diagram showing a coefficient matrix in the embodiment of the present invention.

**Description of the Preferred Embodiments**

The simulation apparatus of the present invention will be described below in detail with reference to the attached drawings.

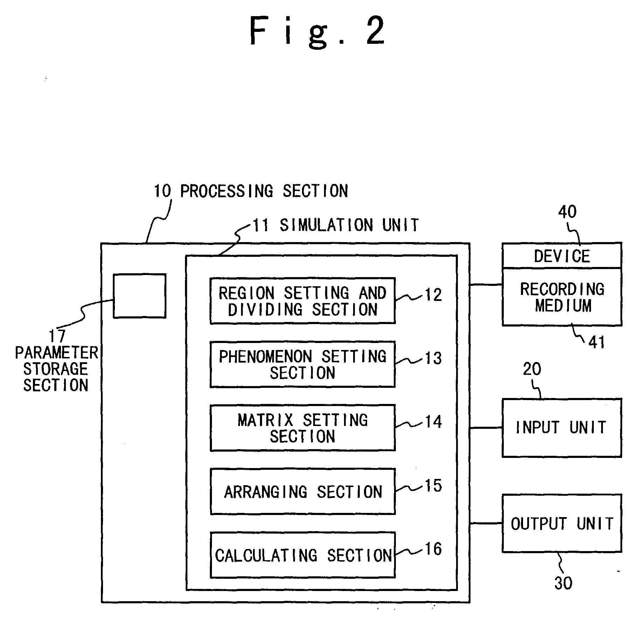

Fig. 2 is a diagram of a simulation apparatus according to the embodiment of the present invention. The simulation apparatus of the present invention is composed of a processing section 10, an input unit 20 and an output unit 30.

The processing section 10 is composed of a simulating unit 11 and a parameter storage section 17. The simulating unit 11 executes algorithms for various simulations. The parameter storage section 17 stores data such as parameters and initial values necessary for the execution of the simulating unit 11, and calculation results in each execution step.

The simulating unit 11 is composed of a region dividing section 12 and a phenomenon setting section 13 . The region dividing section 12 imaginarily divides an object of simulation into a plurality of regions. The phenomenon setting section 13 receives a plurality of equations describing a physical and chemical phenomenon which occurs in each region. The simulating unit 11 is further composed of a matrix setting section 14 and an arranging section 15. The matrix setting section 14 sets a matrix equation to get solution of the plurality of equations, and divides a coefficient matrix of the matrix equation into a plurality of small matrixes. The arranging section 15 rearranges elements in the small matrixes. The simulating means 11 is further composed of a calculating section 16 which determines the solution of the plurality of equations after preconditioning is carried out to the plurality of small matrixes using an incomplete LDU decomposition algorithm

Moreover, the calculating section 16 further has a section for dividing a predetermined time into a plurality of unit times, and executing the above sets of processing for each unit time. At this time, the parameters necessary for the execution in each unit time are determined based on the solution which has been determined in the processing which has been carried out immediately before the execution processing.

Also, the simulating section 11 further has a section for outputting the result determined by the calculating section 16 to the output unit 30. The input unit 20 is composed of a keyboard, a pointing device and so on, and is possible to be used to input data to the processing section 10 and to input a command for the execution of the simulating section 11. The output unit 30 is composed of a display unit, a printer, a storage and so on.

Moreover, the simulating apparatus of the present invention can carry out write and read accesses to a recording medium 41 by a device 40. Also, the processing section 10 can execute an execution program recorded on the recording medium 41.

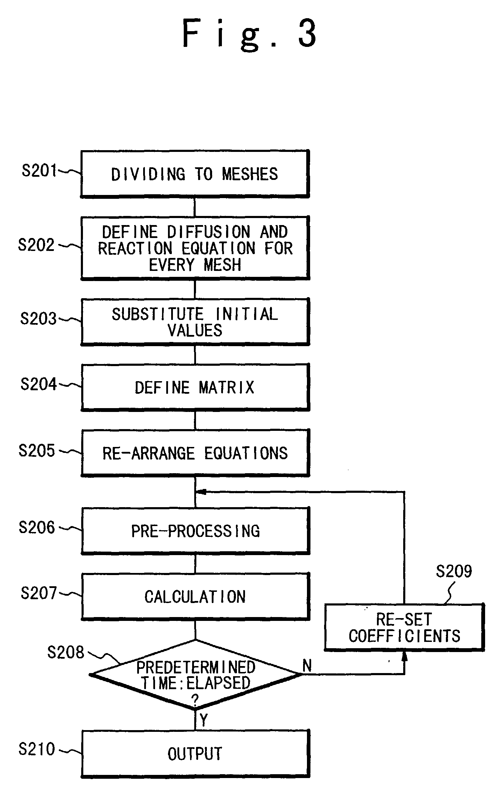

Next, the operation of the present invention will be described below. Fig. 3 is a flow chart showing the operation of the simulation method of the present invention. The execution program is read out from the recording medium 41 by the device 40 and is executed by the processing section 10.

At a step S201, an object is imaginarily divided into a plurality of regions by the region setting and dividing section 12 in response to an instruction supplied from the input unit 20. Each region obtained through the division can be referred to as a mesh point, and stored in the parameter storage section 17.

At a step S202, phenomenon equations which define the change of the state of a system are set for each region by the phenomenon setting section 13 in response to an equation setting instruction supplied from the input unit 20. Also, the phenomenon equations to be set here can determine a state at the time $t+\Delta t$ when a state at time t is given. In this case, $\Delta t$ is a predetermined time interval.

At a step S203, initial coefficients are provided for the phenomenon equations set in the step S202 by the matrix setting section 14 in response to a coefficient setting instruction supplied from the input unit 20 and are stored in the parameter storage section 17. These initial coefficients are given based on the state at the time t0 which indicates a simulation execution start time to each region.

At a step S204, a matrix is produced and set to get solution of the phenomenon equations by the matrix setting section 14 and the coefficient matrix is divided into a plurality of small matrixes by the matrix setting section. The step S204 may be executed in response to an instruction from the input unit 20 or automatically.

At a step S205, the phenomenon equations associated with the elements of each small matrix are grouped into the first equation group and the second equation group. The first equation group is composed of the equations containing the parameters related with the other mesh points and the second equation group is composed of the equations containing the parameters not related with the other mesh points. The coefficients for the equations of the first equation group are arranged from the top in the small matrix in order and then the coefficients for the equations of the second equation group are arranged to follow the above coefficients, by the arranging section 15.

At a step S206, the preconditioning which contains incomplete LDU (low-diagonal, diagonal and upper-diagonal) decomposition as preprocessing is carried out to each small matrixes by the calculating section 16, and the processed coefficients are stored in the parameter storage section 17. At this time, the number of stored elements in the small matrix in a non-diagonal position of the coefficient matrix is reduced less than the original number of elements.

At a step S207, the phenomenon equation to which the preconditioning has been carried out is solved so that the state of the system is determined in the time $t+\Delta t$ to each region.

At a step S208, it is determined whether a predetermined time $\Delta t$ elapsed. When it is determined that the time reaches $t+\Delta t$, a step S210 is executed and when not reaching, a step S209 is executed.

At a step S209, the coefficients of the phenomenon equations are re-set based on the state of the system determined at the step S207 at the time $t+\Delta t$. Then, the step S206 and the subsequent steps are executed by setting the time $t+\Delta t$ as the time t.

At a step S210, the determined result is outputted from the calculating section 16 to the output unit 30. In this case, the result determined after the execution of the step S207 may be outputted to the output unit 30 one after another. Also, the result determined after the execution of the step S207 may be stored in the parameter storage section 17 one after another.

According to this embodiment, the object at the step S201 is the semiconductor in which impurity ions such as boron ions are doped. The phenomenon equations at the step S202 represents generation/extinction of the pairs of impurity ion and point-defect through the diffusion and reaction. Also, the states of the impurity ions, point-defects, holes, electrons becomes necessary to describe the state of the pair of impurity ion and point-defect. Therefore, the phenomenon equations must be set with the initial values and the changes of states of the system due to the diffusion and the reaction.

Also, the number of elements in each small matrix in the column or row direction is equal to the number of phenomenon equations set in the step S202 and the small matrix is a square matrix. A group of the reaction and diffusion equations as the phenomenon equations describing the behavior of the pairs of impurity and point-defect is classified into two groups in the step S205: ① the equation group having a diffusion term and a reaction term and ② the other group having only the reaction term. The arrangement of equations is carried out in order of ① and ② on each mesh point. This is derived from the following condition.

The diffusion term has coefficients to the neighbor region because there is exchange of material with the neighbor mesh point. In other words, the movement of the material to the neighbor region occurs through a diffusion phenomenon in the time of $\Delta t$.

On the other hand, the reaction term does not have any coefficient to the neighbor region because there is not exchange of material with the neighbor mesh point. In other words, any reaction with the material existing in the neighbor region does not occur in the time of $\Delta t$. This is because the reaction term is the equation which is based on the chemical equilibrium in concentration between materials in the mesh points, and does not have correlation with the phenomenon out of the concerned mesh point.

From the above, ① the coefficient matrix of the equation group which has the diffusion term has a non-diagonal component, but ② the coefficient matrix of the equation group which has only the reaction term does not have a non-diagonal component.

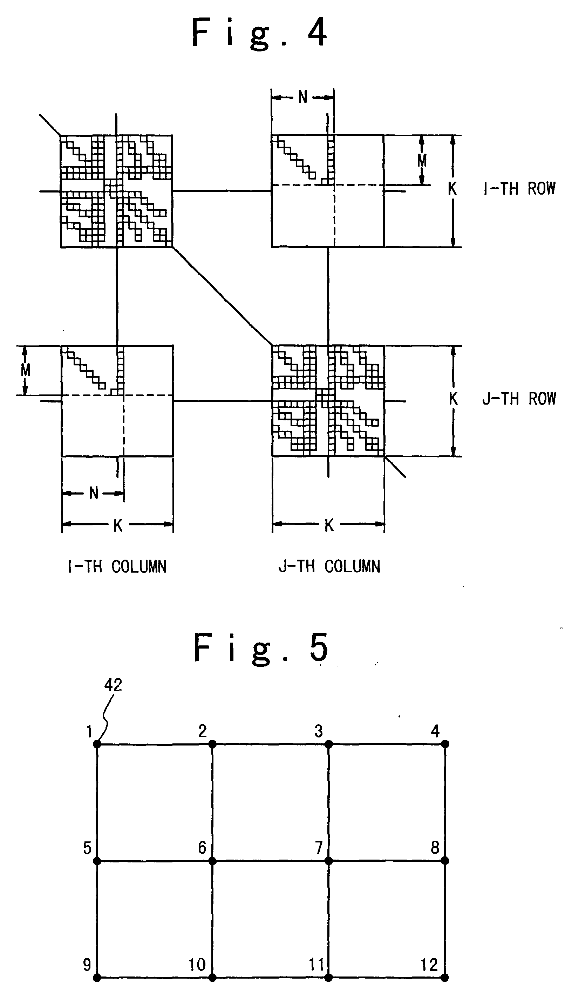

For example, it is supposed that k reaction and diffusion equations as the phenomenon equations are defined in the mesh point $P_{i,j}$ ($i \neq j$) set in the step S201. At this time, as shown in Fig. 4, these phenomenon equations are classified into the m phenomenon equations which have a diffusion term and the (k-m) phenomenon equations which have only the reaction term. When the small matrix having elements of $k \times k$ is produced for every mesh point of the coefficient matrix, the coefficients related with the m phenomenon equations with the diffusion term are first arranged in the upper left portion of the small matrix and then non-zero non-diagonal element (i, j) and (j, i) are settled in the m rows and n columns.

Next, at the step S206, when the coefficient matrix is inverted or transported in a matrix solution using (in)complete LDU decomposition as the preconditioning, the processing relating to the non-diagonal elements (i,j) and (j,i) of the small matrix is limited to the (m × n) portion of the (k × k) small matrix. In the (m × n) portion, the coefficients of the equations related with the diffusion term are stored.

At the step S206, in the case to solve these equations using the (in)complete LDU decomposition, the small matrix of the coefficient matrix related with the phenomenon equations defined on one mesh point is manipulated as one coefficient small matrix. In this case, the storage and calculation of the elements in the small matrixes as non-diagonal elements of the coefficient matrix is limited to a part which is related with the equations which belongs to the ① equation group which contains the diffusion term.

As described above, in each mesh point, it is used that the movement of a material to another mesh point depends on the material and an electric potential. In this case, all the elements other than the elements relating to the material and the electric potential become zero in the non-diagonal element small matrix.

From this, in the small matrix as a non-diagonal element of the coefficient matrix, it is possible to gather the non-zero elements of the small matrix by rearranging the defined phenomenon equations in the order. An calculation is carried out to only the gathered non-zero elements. Thus, the unnecessary multiplication of zero elements can be omitted so that the processing can be speeded up and the used memory region can be reduced.

The reaction equation and the diffusion equation to be used for the simulation of diffusion phenomenon of the pairs of impurity and point-defect will be described below as specific examples.

Fig. 5 is a diagram showing the structure of a 2-dimensional meshes in the specific example. A number at the upper left of a mesh point 42 indicates a mesh number at each of the meshes. The all kinds of reaction equations indicating the reaction of each material which are related with the impurities and the point-defect pair diffusion phenomenon in this embodiment are shown by the following equations (1) to (5).

$$I^0 + V^0 \xrightleftharpoons{k_1} \Phi \qquad (1)$$

$$I^0 + h^+ \xrightleftharpoons[k_2^r]{k_2^f} I^+ \qquad (2)$$

$$B + I^+ \xrightleftharpoons[k_3^r]{k_3^f} BI^+ + e^- \qquad (3)$$

$$BI^+ + V^0 \xrightleftharpoons[k_4^r]{k_4^f} B^- + 2h^+ \qquad (4)$$

$$B^- + BI^+ \xrightleftharpoons[k_5^r]{k_5^f} BB_{cls} \qquad (5)$$

where Ix indicates a silicon atom between the lattices (the attached character x indicates each electric charge), Vx indicates a vacancy in the crystal, $\Phi$ in the right side of the equation (1) indicates an empty set, $B^-$ is a boron atom and shows an anion with 1 valence, $BI^+$ shows a pair of boron atom and silicon atom between the lattices, $BB_{cls}$ shows two boron atoms which are combined with each other, $e^-$ shows an electron and $h^+$ shows a hole, and $k_n^f$ and $k_n^r$ which are used in each equation are a positive reaction coefficient and an inverse reaction coefficient in each reaction equation.

The equation (1) is a reaction equation showing the generation and extinction of the point-defect in the silicon crystal. The equation (2) is the reaction equation that an electric charge is given to the silicon atom between the lattices. The equation (3) is a reaction equation showing the generation and separation of the pair of boron atom and silicon atom between the lattices. The equation (4) is a reaction equation showing interaction between boron atom and silicon atom pair and vacancy. The equation (5) is a reaction equation showing the formation and dissociation of two combined boron atoms which exist in the lattice defect which is squeezed between the lattices without any diffusion.

Next, the equations defining change of each material is defined after a small time elapses will be described below.

$$\frac{\partial C_{V^0}}{\partial t} = \frac{\partial}{\partial x}\left[D_{V^0}\frac{\partial C_{V^0}}{\partial x}\right] - k_4^f C_{BI^+}C_{V^0} + k_4^r C_{B^-}p^2 - k_1\left(C_{I^0}C_{V^0} - C_{I^0}^* C_{V^0}^*\right)$$

$$(6)$$

$$\frac{\partial C_{I^0}}{\partial t} = \frac{\partial}{\partial x}\left[D_{I^0}\frac{\partial C_{I^0}}{\partial x}\right] - k_2^f C_{I^0}p + k_2^r C_{I^+} - k_1\left(C_{I^0}C_{V^0} - C_{I^0}^* C_{V^0}^*\right)$$

$$(7)$$

$$\frac{\partial C_{I^+}}{\partial t} = \frac{\partial}{\partial x}\left[D_{I^+}\frac{\partial C_{I^+}}{\partial x} + \frac{q}{kT}D_{I^+}C_{I^+}\frac{\partial \phi}{\partial x}\right] \qquad (8)$$
$$- k_3^f C_{B^-}C_{I^+} + k_3^r C_{BI^+}n + k_2^f C_{I^0}p - k_2^r C_{I^+}$$

$$\frac{\partial C_{BI^+}}{\partial t} = \frac{\partial}{\partial x}\left[D_{BI^+}\frac{\partial C_{BI^+}}{\partial x} + \frac{q}{kT}D_{BI^+}C_{BI^+}\frac{\partial \phi}{\partial x}\right] + k_3^f C_{B^-}C_{I^+} - k_3^r C_{BI^+}n$$
$$- k_4^f C_{BI^+}C_{V^0} + k_4^r C_{B^-}p^2 - k_5^f C_{B^-}C_{BI^+} + k_5^r C_{BB_{cls}}$$

$$(9)$$

$$\frac{\partial C_{B^-}}{\partial t} = -k_3^f C_{B^-}C_{I^+} + k_3^r C_{BI^+}n + k_4^f C_{BI^+}C_{V^0} - k_4^r C_{B^-}p^2$$
$$- k_5^f C_{B^-}C_{BI^+} + k_5^r C_{BB_{cls}} \qquad (10)$$

$$\frac{\partial C_{BB_{cls}}}{\partial t} = k_5^f C_{B^-}C_{BI^+} - k_5^r C_{BB_{cls}} \qquad (11)$$

In the above-mentioned equations, Cx shows a concentration of the material which is defined in the attaching character x (for example, V0, I0).

The concentration changes of V0 and I0 shown by the equations (6) and (7) are caused with the diffusion phenomenon and the reaction phenomenon. The diffusion phenomenon depends on the kinetic energy of the material. However, the concentration changes of $I^+$ and $BI^+$ shown by the equations (8) and (9) are caused with the diffusion phenomenon and the reaction phenomenon. The diffusion phenomenon depends on the kinetic energy of the element and the electric field determined based on the gradient of the electric potential between the mesh points. Therefore, the quantity indicating an electric potential is contained in the diffusion term.

Also, the equations of $B^-$ and $BB_{cls}$ expressed by the equations (10) and (11) are possible to be approximated as no diffusion operation is performed, because the diffusion rates of $B^-$ and $BB_{cls}$ themselves are small sufficiently compared with the other material. Therefore, the equations can be written to have only a reaction term.

The equation indicating an electrostatic potential in each mesh point is shown as the following equation (12).

$$\nabla(\varepsilon\nabla\varphi) = -q(C_{I+} + C_{BI+} - C_{B-} - n \cdot \exp(\frac{q\varphi}{k_B T}) + n \cdot \exp(-\frac{q\varphi}{k_B T})) \qquad (12)$$

Because the quadratic differentiation equations to the position is contained in the left side term of the equation (12), it could be understood that the electrostatic potential has an influence on the other mesh points. The equations (6) to (12) can be solved simultaneously to obtain solution to each material in each mesh point. Thus, it is possible to simulate the diffusion phenomenon of the pairs of impurity and point-defect. The solving method will be shown below.

The equations obtained when the behaviors of materials expressed by use of the equations (6) to (12) are discretized to the 2-dimensional meshes shown in Fig. 5 are the following equations (13) to (19).

$$S_i \frac{C_{V^0}(x_i, t_{k+1}) - C_{V^0}(x_i, t_k)}{t_{k+1} - t_k}$$
$$= \sum_j W_{i,j} D_{V^0, i, j} \frac{C_{V^0}(x_j, t_{k+1}) - C_{V^0}(x_i, t_{k+1})}{|x_j - x_i|}$$
$$- S_i k_4^f C_{BI+}(x_i, t_{k+1}) C_{V^0}(x_i, t_{k+1}) + S_i k_4^r C_{B-}(x_i, t_{k+1}) n_i^2 \exp(-\frac{2q\varphi(x_i, t_{k+1})}{k_B T})$$
$$- S_i k_1 (C_{I^0}(x_i, t_{k+1}) C_{V^0}(x_i, t_{k+1}) - C_{I^0}^* C_{V^0}^*)$$

$$(13)$$

The equation (13) indicates the equation when the equation (6) is discretized.

$$S_i \frac{C_{I^0}(x_i, t_{k+1}) - C_{I^0}(x_i, t_k)}{t_{k+1} - t_k}$$
$$= \sum_j W_{i,j} D_{I^0, i, j} \frac{C_{I^0}(x_j, t_{k+1}) - C_{I^0}(x_i, t_{k+1})}{|x_j - x_i|}$$
$$- S_i k_2^f C_{I^0}(x_i, t_{k+1}) n_i \exp(-\frac{q\varphi(x_i, t_{k+1})}{k_B T}) + S_i k_2^r C_{I+}(x_i, t_{k+1})$$
$$- S_i k_1 (C_{I^0}(x_i, t_{k+1}) C_{V^0}(x_i, t_{k+1}) - C_{I^0}^* C_{V^0}^*)$$

$$(14)$$

The equation (14) shows the equation when the equation (7) is discretized.

$$S_i \frac{C_{I^+}(x_i, t_{k+1}) - C_{I^+}(x_i, t_k)}{t_{k+1} - t_k} =$$

$$\sum_j W_{i,j} D_{I^+, i, j} \left( \frac{B(\varphi(x_j, t_{k+1}) - \varphi(x_i, t_{k+1})) C_{I^+}(x_j, t_{k+1})}{|x_j - x_i|} \right.$$

$$\left. - \frac{B(\varphi(x_i, t_{k+1}) - \varphi(x_j, t_{k+1})) C_{I^+}(x_i, t_{k+1})}{|x_j - x_i|} \right)$$

$$- S_i k_3^f C_{B^-}(x_i, t_{k+1}) C_{I^+}(x_i, t_{k+1}) + S_i k_3^r C_{BI^+}(x_i, t_{k+1}) n_i \exp\left(\frac{q\varphi(x_i, t_{k+1})}{k_B T}\right)$$

$$+ S_i k_2^f C_{I^0}(x_i, t_{k+1}) n_i \exp\left(-\frac{q\varphi(x_i, t_{k+1})}{k_B T}\right) - S_i k_2^r C_{I^+}(x_i, t_{k+1})$$

$$\because B(y) = \frac{\dfrac{qy}{k_B T}}{\exp\left(\dfrac{qy}{k_B T}\right) - 1}$$

( 1 5 )

The equation (15) shows the equation when the equation (8) is discretized.

$$S_i \frac{C_{BI^+}(x_i,t_{k+1}) - C_{BI^+}(x_i,t_k)}{t_{k+1}-t_k}$$

$$= \sum_j W_{i,j} D_{BI^+,i,j} \left( \frac{B(\varphi(x_j,t_{k+1}) - \varphi(x_i,t_{k+1})) C_{BI^+}(x_j,t_{k+1})}{x_j - x_i}\right.$$

$$\left. - \frac{B(\varphi(x_i,t_{k+1}) - \varphi(x_j,t_{k+1})) C_{BI^+}(x_i,t_{k+1})}{|x_j - x_i|} \right)$$

$$+ S_i k_3^f C_{B^-}(x_i,t_{k+1}) C_{I^+}(x_i,t_{k+1}) - S_i k_3^r C_{BI^+}(x_i,t_{k+1}) n_i \exp(\frac{q\varphi(x_i,t_{k+1})}{k_B T})$$

$$- S_i k_4^f C_{BI^+}(x_i,t_{k+1}) C_{V^0}(x_i,t_{k+1}) + S_i k_4^r C_{B^-}(x_i,t_{k+1}) n_i^2 \exp(-\frac{2q\varphi(x_i,t_{k+1})}{k_B T})$$

$$- S_i k_5^f C_{B^-}(x_i,t_{k+1}) C_{BI^+}(x_i,t_{k+1}) + S_i k_5^r C_{BB_{cls}}(x_i,t_{k+1})$$

$$\because B(y) = \frac{\dfrac{qy}{k_B T}}{\exp(\dfrac{qy}{k_B T}) - 1}$$

$$(16)$$

The equation (16) shows the equation when the equation (9) is discretized.

$$S_i \frac{C_{B^-}(x_i,t_{k+1}) - C_{B^-}(x_i,t_k)}{t_{k+1}-t_k}$$

$$= -S_i k_3^f C_{B^-}(x_i,t_{k+1}) C_{I^+}(x_i,t_{k+1}) + S_i k_3^r C_{BI^+}(x_i,t_{k+1}) n_i \exp(\frac{q\varphi(x_i,t_{k+1})}{k_B T})$$

$$+ S_i k_4^f C_{BI^+}(x_i,t_{k+1}) C_{V^0}(x_i,t_{k+1}) - S_i k_4^r C_{B^-}(x_i,t_{k+1}) n_i^2 \exp(-\frac{2q\varphi(x_i,t_{k+1})}{k_B T})$$

$$- S_i k_5^f C_{B^-}(x_i,t_{k+1}) C_{BI^+}(x_i,t_{k+1}) + S_i k_5^r C_{BB_{cls}}(x_i,t_{k+1})$$

$$(17)$$

The equation (17) shows the equation when the equation (10) is discretized.

$$S_i \frac{C_{BB_{cls}}(x_i, t_{k+1}) - C_{BB_{cls}}(x_i, t_k)}{t_{k+1} - t_k}$$

$$= S_i k_5^f C_{B^-}(x_i, t_{k+1}) C_{BI^+}(x_i, t_{k+1}) - S_i k_5^r C_{BB_{cls}}(x_i, t_{k+1})$$

$$(18)$$

The equation (18) shows the equation when the equation (11) is discretized.

$$\sum_j W_{i,j} \varepsilon_{S_i,i,j} \frac{\varphi(x_j, t_{k+1}) - \varphi(x_i, t_{k+1}))}{|x_j - x_i|}$$

$$= -q S_i (C_{I^+}(x_i, t_{k+1}) + C_{BI^+}(x_i, t_{k+1}) - C_{B^-}(x_i, t_{k+1})$$

$$- n_i \exp(\frac{q\varphi(x_i, t_{k+1})}{k_B T}) + n_i \exp(-\frac{q\varphi(x_i, t_{k+1})}{k_B T}))$$

$$(19)$$

The equation (19) shows the equation when the equation (12) is discretized. Here, Si is a control volume in a mesh point i, $W_{i,j}$ is a diffusion flux passage cross section related with a mesh branch i-j, and ni is an intrinsic carrier density in the mesh point i.

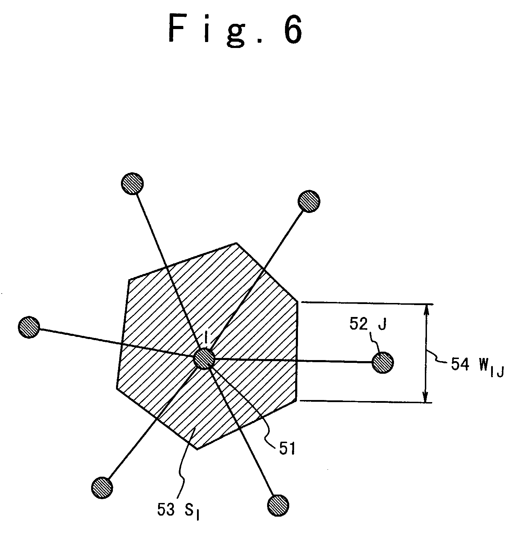

As shown in Fig. 6, distances between the mesh point i 51 and the respective mesh points around the mesh point i 51 are compared. In this case, the control volume Si 53 is a set of the mesh points near the mesh point i 51. The control volume Si 53 is expressed by the length of the segment, in case of one dimension, the area of the region in case of two dimensions, and the solid volume in case of the three dimensions. The flux passage cross section $W_{i,j}$ 54 is the set of the mesh points which are located to have equal distances from the mesh point i 51 and the mesh point j 52 and to be closer than the other mesh points. The flux passage cross section $W_{i,j}$ 54 is expressed as the points in case of one dimension, as the length of the segment in case of two dimensions, and as the area of the region in case of the three dimensions. In this embodiment, because the simulation is carried out as the 2-dimensional meshes arrangement, the control volume Si 53 is shown as the area of the region and the flux passage cross section $W_{i,j}$ 54 is shown as the length of the segment. Also, $x_i$ shows a vector pointing out the mesh point i and $t_k$ shows the k-th one of the divided times. Also, $\varepsilon_{Si,i,j}$ shown in the equation (19) shows a dielectric constant of silicon.

Next, a linearization is carried out to the equations (13) to (19) which are obtained through the discretization using the Newton's method. As a result, the following equations (20) to (26) are obtained.

$$\sum_j \left( \frac{\partial F_{V^0}(x_i,t_{k+1})}{\partial C_{V^0}(x_j,t_{k+1})} \delta C_{V^0}(x_j,t_{k+1}) + \frac{\partial F_{V^0}(x_i,t_{k+1})}{\partial C_{I^0}(x_j,t_{k+1})} \delta C_{I^0}(x_j,t_{k+1}) \right.$$

$$+ \frac{\partial F_{V^0}(x_i,t_{k+1})}{\partial C_{BI^+}(x_j,t_{k+1})} \delta C_{BI^+}(x_j,t_{k+1}) + \frac{\partial F_{V^0}(x_i,t_{k+1})}{\partial C_{B^-}(x_j,t_{k+1})} \delta C_{B^-}(x_j,t_{k+1})$$

$$+ \frac{\partial F_{V^0}(x_i,t_{k+1})}{\partial C_\varphi(x_j,t_{k+1})} \delta C_\varphi(x_j,t_{k+1}) \left. \right) = -F_{V^0}(x_i,t_{k+1})$$

$$\because F_{V^0}(x_i,t_{k+1}) = S_i \frac{C_{V^0}(x_i,t_{k+1}) - C_{V^0}(x_i,t_k)}{t_{k+1} - t_k}$$

$$- \sum_j W_{i,j} D_{V^0,i,j} \frac{C_{V^0}(x_j,t_{k+1}) - C_{V^0}(x_i,t_{k+1})}{|x_j - x_i|}$$

$$+ S_i k_4^f C_{BI^+}(x_i,t_{k+1}) C_{V^0}(x_i,t_{k+1})$$

$$- S_i k_4^r C_{B^-}(x_i,t_{k+1}) n_i^2 \exp\left(-\frac{2q\varphi(x_i,t_{k+1})}{k_B T}\right)$$

$$+ S_i k_1 (C_{I^0}(x_i,t_{k+1}) C_{V^0}(x_i,t_{k+1}) - C_{I^0}^* C_{V^0}^*)$$

$$(20)$$

The left side of the equation (20) shows the terms obtained through the linearization of the equation (13) using the Newton's method.

$$\sum_j \left( \frac{\partial F_{I^0}(x_i,t_{k+1})}{\partial C_{V^0}(x_j,t_{k+1})} \delta C_{V^0}(x_j,t_{k+1}) + \frac{\partial F_{I^0}(x_i,t_{k+1})}{\partial C_{I^0}(x_j,t_{k+1})} \delta C_{I^0}(x_j,t_{k+1}) \right.$$

$$+ \frac{\partial F_{I^0}(x_i,t_{k+1})}{\partial C_{I^+}(x_j,t_{k+1})} \delta C_{B^-}(x_j,t_{k+1}) + \frac{\partial F_{I^0}(x_i,t_{k+1})}{\partial C_\varphi(x_j,t_{k+1})} \delta C_\varphi(x_j,t_{k+1}) \left. \right)$$

$$= -F_{I^0}(x_i,t_{k+1})$$

$$\therefore F_{I^0}(x_i, t_{k+1}) = S_i \frac{C_{I^0}(x_i, t_{k+1}) - C_{I^0}(x_i, t_k)}{t_{k+1} - t_k}$$

$$- \sum_j W_{i,j} D_{I^0, i, j} \frac{C_{I^0}(x_j, t_{k+1}) - C_{I^0}(x_i, t_{k+1})}{|x_j - x_i|}$$

$$+ S_i k_2^f C_{I^0}(x_i, t_{k+1}) n_i \exp(-\frac{q\varphi(x_i, t_{k+1})}{k_B T}) - S_i k_2^r C_{I^+}(x_i, t_{k+1})$$

$$+ S_i k_1 (C_{I^0}(x_i, t_{k+1}) C_{V^0}(x_i, t_{k+1}) - C_{I^0}^* C_{V^0}^*)$$

$$(21)$$

The left side of the equation (21) shows the terms obtained through the linearization of the equation (14) using the Newton's method.

$$\sum_j \left( \frac{\partial F_{I^+}(x_i, t_{k+1})}{\partial C_{I^0}(x_j, t_{k+1})} \delta C_{I^0}(x_j, t_{k+1}) + \frac{\partial F_{I^+}(x_i, t_{k+1})}{\partial C_{I^+}(x_j, t_{k+1})} \delta C_{I^+}(x_j, t_{k+1}) \right.$$

$$+ \frac{\partial F_{I^+}(x_i, t_{k+1})}{\partial C_{BI^+}(x_j, t_{k+1})} \delta C_{BI^+}(x_j, t_{k+1}) + \frac{\partial F_{I^+}(x_i, t_{k+1})}{\partial C_{B^-}(x_j, t_{k+1})} \delta C_{B^-}(x_j, t_{k+1})$$

$$\left. + \frac{\partial F_{I^+}(x_i, t_{k+1})}{\partial C_\varphi(x_j, t_{k+1})} \delta C_\varphi(x_j, t_{k+1}) \right) = -F_{I^+}(x_i, t_{k+1})$$

$$\therefore F_{I^+}(x_i, t_{k+1}) = S_i \frac{C_{I^+}(x_i, t_{k+1}) - C_{I^+}(x_i, t_k)}{t_{k+1} - t_k}$$

$$- \sum_j W_{i,j} D_{I^+, i, j} \left( \frac{B(\varphi(x_j, t_{k+1}) - \varphi(x_i, t_{k+1})) C_{I^+}(x_j, t_{k+1})}{|x_j - x_i|} \right.$$

$$\left. - \frac{B(\varphi(x_i, t_{k+1}) - \varphi(x_j, t_{k+1})) C_{I^+}(x_i, t_{k+1})}{|x_j - x_i|} \right)$$

$$+ S_i k_3^f C_{B^-}(x_i, t_{k+1}) C_{I^+}(x_i, t_{k+1})$$

$$- S_i k_3^r C_{BI^+}(x_i, t_{k+1}) n_i \exp(\frac{q\varphi(x_i, t_{k+1})}{k_B T})$$

$$- S_i k_2^f C_{I^0}(x_i, t_{k+1}) n_i \exp(-\frac{q\varphi(x_i, t_{k+1})}{k_B T}) + S_i k_2^r C_{I^+}(x_i, t_{k+1})$$

$$(22)$$

The left side of the equation (22) shows the terms obtained through the linearization of the equation (15) using the Newton's method.

$$\sum_{j}(\frac{\partial F_{BI^+}(x_i,t_{k+1})}{\partial C_{V^0}(x_j,t_{k+1})}\delta C_{V^0}(x_j,t_{k+1}) + \frac{\partial F_{BI^+}(x_i,t_{k+1})}{\partial C_{I^+}(x_j,t_{k+1})}\delta C_{I^+}(x_j,t_{k+1})$$

$$+ \frac{\partial F_{BI^+}(x_i,t_{k+1})}{\partial C_{BI^+}(x_j,t_{k+1})}\delta C_{BI^+}(x_j,t_{k+1}) + \frac{\partial F_{BI^+}(x_i,t_{k+1})}{\partial C_{B^-}(x_j,t_{k+1})}\delta C_{B^-}(x_j,t_{k+1})$$

$$+ \frac{\partial F_{BI^+}(x_i,t_{k+1})}{\partial C_{BB_{cls}}(x_j,t_{k+1})}\delta C_{BB_{cls}}(x_j,t_{k+1}) + \frac{\partial F_{BI^+}(x_i,t_{k+1})}{\partial C_\varphi(x_j,t_{k+1})}\delta C_\varphi(x_j,t_{k+1}))$$

$$= -F_{BI^+}(x_i,t_{k+1})$$

$$\because F_{BI^+}(x_i,t_{k+1}) = S_i \frac{C_{BI^+}(x_i,t_{k+1}) - C_{BI^+}(x_i,t_k)}{t_{k+1} - t_k}$$

$$- \sum_{j}W_{i,j}D_{BI^+,i,j}(\frac{B(\varphi(x_j,t_{k+1}) - \varphi(x_i,t_{k+1}))C_{BI^+}(x_j,t_{k+1})}{|x_j - x_i|}$$

$$- \frac{B(\varphi(x_i,t_{k+1}) - \varphi(x_j,t_{k+1}))C_{BI^+}(x_i,t_{k+1})}{|x_j - x_i|})$$

$$- S_i k_3^f C_{B^-}(x_i,t_{k+1})C_{I^+}(x_i,t_{k+1})$$

$$+ S_i k_3^r C_{BI^+}(x_i,t_{k+1})n_i \exp(\frac{q\varphi(x_i,t_{k+1})}{k_BT})$$

$$+ S_i k_4^f C_{BI^+}(x_i,t_{k+1})C_{V^0}(x_i,t_{k+1})$$

$$- S_i k_4^r C_{B^-}(x_i,t_{k+1})n_i^2 \exp(-\frac{2q\varphi(x_i,t_{k+1})}{k_BT})$$

$$+ S_i k_5^f C_{B^-}(x_i,t_{k+1})C_{BI^+}(x_i,t_{k+1}) - S_i k_5^r C_{BB_{cls}}(x_i,t_{k+1})$$

$$(23)$$

The left side of the equation (23) shows the terms obtained through the linearization of the equation (16) using the Newton's method.

$$\sum_j (\frac{\partial F_{B^-}(x_i,t_{k+1})}{\partial C_{V^0}(x_j,t_{k+1})} \delta C_{V^0}(x_j,t_{k+1}) + \frac{\partial F_{B^-}(x_i,t_{k+1})}{\partial C_{I^+}(x_j,t_{k+1})} \delta C_{I^+}(x_j,t_{k+1})$$

$$+ \frac{\partial F_{B^-}(x_i,t_{k+1})}{\partial C_{BI^+}(x_j,t_{k+1})} \delta C_{BI^+}(x_j,t_{k+1}) + \frac{\partial F_{B^-}(x_i,t_{k+1})}{\partial C_{B^-}(x_j,t_{k+1})} \delta C_{B^-}(x_j,t_{k+1})$$

$$+ \frac{\partial F_{B^-}(x_i,t_{k+1})}{\partial C_{BB_{cls}}(x_j,t_{k+1})} \delta C_{BB_{cls}}(x_j,t_{k+1}) + \frac{\partial F_{B^-}(x_i,t_{k+1})}{\partial C_\varphi(x_j,t_{k+1})} \delta C_\varphi(x_j,t_{k+1}))$$

$$= -F_{B^-}(x_i,t_{k+1})$$

$$\because F_{B^-}(x_i,t_{k+1}) = S_i \frac{C_{B^-}(x_i,t_{k+1}) - C_{B^-}(x_i,t_k)}{t_{k+1} - t_k}$$

$$+ S_i k_3^f C_{B^-}(x_i,t_{k+1}) C_{I^+}(x_i,t_{k+1})$$

$$- S_i k_3^r C_{BI^+}(x_i,t_{k+1}) n_i \exp(\frac{q\varphi(x_i,t_{k+1})}{k_B T})$$

$$- S_i k_4^f C_{BI^+}(x_i,t_{k+1}) C_{V^0}(x_i,t_{k+1})$$

$$+ S_i k_4^r C_{B^-}(x_i,t_{k+1}) n_i^2 \exp(-\frac{2q\varphi(x_i,t_{k+1})}{k_B T})$$

$$+ S_i k_5^f C_{B^-}(x_i,t_{k+1}) C_{BI^+}(x_i,t_{k+1}) - S_i k_5^r C_{BB_{cls}}(x_i,t_{k+1})$$

$$( 2 4 )$$

The left side of the equation (24) shows the terms obtained through the linearization of the equation (17) using the Newton's method.

$$\sum_j (\frac{\partial F_{BB_{cls}}(x_i,t_{k+1})}{\partial C_{BI^+}(x_j,t_{k+1})} \delta C_{BI^+}(x_j,t_{k+1}) + \frac{\partial F_{BB_{cls}}(x_i,t_{k+1})}{\partial C_{B^-}(x_j,t_{k+1})} \delta C_{B^-}(x_j,t_{k+1})$$

$$+ \frac{\partial F_{BB_{cls}}(x_i,t_{k+1})}{\partial C_{BB_{cls}}(x_j,t_{k+1})} \delta C_{BB_{cls}}(x_j,t_{k+1})) = -F_{BB_{cls}}(x_i,t_{k+1})$$

$$\because F_{BB_{cls}}(x_i,t_{k+1}) = S_i \frac{C_{BB_{cls}}(x_i,t_{k+1}) - C_{BB_{cls}}(x_i,t_k)}{t_{k+1} - t_k}$$

$$- S_i k_5^f C_{B^-}(x_i,t_{k+1}) C_{BI^+}(x_i,t_{k+1}) + S_i k_5^r C_{BB_{cls}}(x_i,t_{k+1})$$

$$( 2 5 )$$

The left side of the equation (25) shows the terms obtained through the linearization of the equation (18) using the Newton's method.

$$\sum_{j}(\frac{\partial F_{\varphi}(x_i,t_{k+1})}{\partial C_{I^+}(x_j,t_{k+1})}\delta C_{I^+}(x_j,t_{k+1})+\frac{\partial F_{\varphi}(x_i,t_{k+1})}{\partial C_{BI^+}(x_j,t_{k+1})}\delta C_{BI^+}(x_j,t_{k+1})$$

$$+\frac{\partial F_{\varphi}(x_i,t_{k+1})}{\partial C_{B^-}(x_j,t_{k+1})}\delta C_{B^-}(x_j,t_{k+1})+\frac{\partial F_{\varphi}(x_i,t_{k+1})}{\partial C_{\varphi}(x_j,t_{k+1})}\delta C_{\varphi}(x_j,t_{k+1}))$$

$$= -F_{\varphi}(x_i,t_{k+1})$$

$$\because F_{\varphi}(x_i,t_{k+1}) = \sum_{j}W_{i,j}\varepsilon_{S_i,i,j}\frac{\varphi(x_j,t_{k+1})-\varphi(x_i,t_{k+1}))}{|x_j-x_i|}$$

$$+qSi(C_{I^+}(x_i,t_{k+1})+C_{BI^+}(x_i,t_{k+1})-C_{B^-}(x_i,t_{k+1})$$

$$-n_i\exp(\frac{q\varphi(x_i,t_{k+1})}{k_BT})+n_i\exp(-\frac{q\varphi(x_i,t_{k+1})}{k_BT}))$$

$$(2\,6\,)$$

The left side of the equation (26) shows the terms obtained through the linearization of the equation (19) using the Newton's method.

The term shown by $F_n(x_i, t_{i+1})$ here is called a residual term of the element n, and is obtained by subtracting a right side from the left side in each of the equations (13) to (19) for every corresponding element. Therefore, $F_n(x_i, t_{i+1})$ is shown by a non-linear equation.

The simultaneous equations of the equations (20) to (26) for every mesh point is expressed by the following equation (27).

$$\left(\frac{\partial F}{\partial C}\right)\cdot(\delta C) = -(F)\qquad\qquad(27)$$

where C is a matrix which is composed of a concentration function and an electrostatic potential function to each material to all mesh points. More specifically, it is expressed by the following equation (28).

$$C={}^t(C_{V^0}(x_1,t_{k+1}),C_{I^0}(x_1,t_{k+1}),C_{I^+}(x_1,t_{k+1}),C_{BI^+}(x_1,t_{k+1}),\varphi(x_1,t_{k+1})$$

$$,C_{B^-}(x_1,t_{k+1}),C_{BB_{cls}}(x_1,t_{k+1}),\cdots,C_{BB_{cls}}(x_{14},t_{k+1}))$$

$$(2\,8\,)$$

where F is a matrix which is composed of the residual terms of each material to all the mesh points, and more specifically, it is expressed by the following equation (29).

$$F={}^t(F_{V^0}(x_1,t_{k+1}),F_{I^0}(x_1,t_{k+1}),F_{I^+}(x_1,t_{k+1}),F_{BI^+}(x_1,t_{k+1}),F_{\varphi}(x_1,t_{k+1})$$

$$,F_{B^-}(x_1,t_{k+1}),F_{BB_{cls}}(x_1,t_{k+1}),\cdots,F_{BB_{cls}}(x_{14},t_{k+1}))$$

$$(2\,9\,)$$

Also, the matrix shown in the left side first term of the equation (27) is a coefficient matrix and is shown by the following equation (30).

$$\left(\frac{\partial F}{\partial C}\right) \tag{30}$$

More specifically, when it is supposed that the m column of F is expressed by $E_m$, n column of C is expressed by $C_n$, and an element of the coefficient matrix at m-th row and n-th column is $E_{m,n}$, $E_{m,n}$ is expressed by the following equation (31).

$$E_{m,n} = \frac{\partial F_m}{\partial C_n} \tag{31}$$

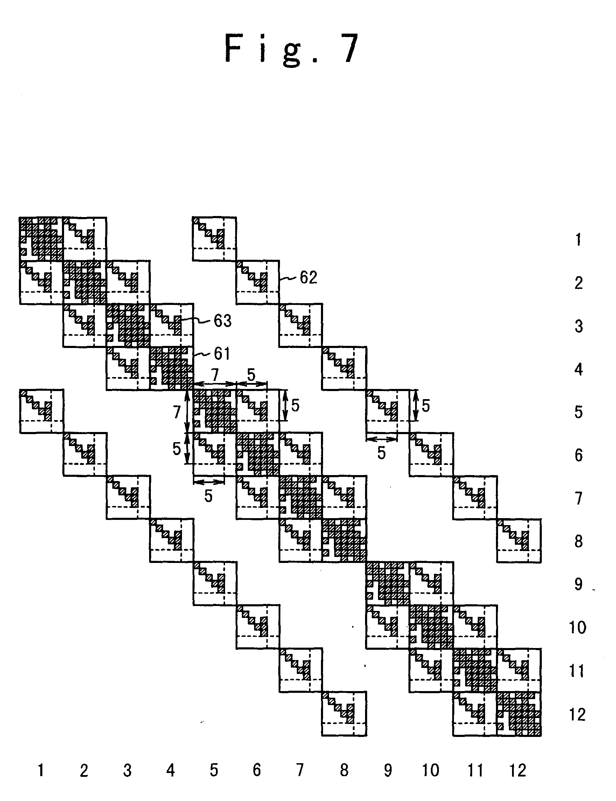

Referring to the equations (6) to (12), the equations which have an influence to the neighbor mesh points are the equations (6) to (9) and (12). The equations which do not have an influence to the neighbor mesh points are the equations (10) and (11). When the equation (27) is expressed by collecting the equations (20) to (23) and (26) in the upper portion and the equations (24) and (25) are collected in the lower portion, the coefficient matrix of the equation (27) is shown in Fig. 7.

The coefficient matrix is divided into small matrixes of the square matrix (7 rows and 7 columns in this example) which is composed of elements for the number of equations per each mesh point in the row and column directions. In this case, the coefficient matrix includes small matrixes 61 as diagonal elements, each of which contains non-zero elements 63 in 7 rows and 7 columns and the small matrixes 62 as non-diagonal elements, each of which contains the non-zero element 63 in 5 rows and 5 columns. The small matrix as a non-diagonal element of the coefficient matrix is possible to be substantially reduced in size, compared with the small matrix at the time of division.

The preconditioning is carried out to the coefficient matrix shown in Fig. 7. After the preconditioning, by inverting or transporting the coefficient matrix expressed by the equation (30) and solving the equation of the equation (27), each element of the matrix expressed by the equation of the equation (28) is determined. At this time, each element of the matrix expressed by the equation (28) when the residual term as each matrix element of the equation (29) is less than a predetermined value is a value to be determined.

By the way, in the incomplete LDU decomposition shown in the step S206, the positions of non-zero small matrixes of a lower triangular matrix (L) and an upper triangular matrix (U) which have been produced through the LDU decomposition are limited to a given non-zero pattern. Here, it is supposed that P is a set of non-zero small matrix positions given previously. However, diagonal elements and non-zero elements of the original matrix A are supposed to be always contained in P.

A matrix M obtained through a small matrix incomplete LDU decomposition is given by the following equation (32).

$$M = (L+D)D^{-1}(D+U) = L+D+U+LD^{-1}U \tag{32}$$

where the small matrixes of L, D and U are expressed as $L_{I,J}$, $D_{I,J}$ and $U_{I,J}$, the small matrixes of the original matrix A are expressed as $A_{I,J}$ and N is the number of small matrixes in either of the column direction and row direction. The matrix M given by the equation (32) must be coincident with the matrix A with respect to the non-zero pattern P. This necessary and sufficient condition is that the following equations (33) to (35) are satisfied over all the elements which meet partial matrix element $(I,J) \in P$.

$$L_{I,J} = A_{I,J} - \sum_{(I,K)\in P,(K,J)\in P,I>K,J>K} L_{I,K}D_K^{-1}U_{K,J} \quad if \quad I > J \qquad (33)$$

$$D_I = A_{I,J} - \sum_{(I,K)\in P,I>K} L_{I,K}D_K^{-1}U_{K,J} \qquad (34)$$

$$U_{I,J} = A_{I,J} - \sum_{(J,K)\in P,(K,J)\in P,I>K,J>K} L_{I,K}D_K^{-1}U_{K,J} \quad if \quad J > I \qquad (35)$$

Otherwise, with the non-zero element P, the non-zero elements of the original matrix A are satisfied by the equations (33) to (35). The non-zero element determined when the element determined by $LD^{-1}U$ is the zero element of the original matrix A is taken into P. Thus, it is possible to produce a preconditioning matrix with better approximation. Also, this processing can be repeated.

Next, the preconditioning shown at the step S205 will be described below. The preconditioning is concerned with an algorithm for solving the equation expressed by the following equation (36).

$$(L+D)D^{-1}(D+U)x = y \qquad (36)$$

The equation (36) is composed of the forward substitution shown by the following equation (37) and the backward substitution shown by the following equation (38).

$$(L+D)t = y \qquad (37)$$

$$D^{-1}(D+U)x = (I+D^{-1}U)x = t \qquad (38)$$

As a modification example of the present invention, when the number and the kinds of equations defined for every mesh point are different, the values of m and n change for every small matrix as non-diagonal element of the coefficient matrix. However, even in such a case, by referring to the equations on the movement of the element from each mesh point to the other mesh points, gathering non-zero elements in the range of $m(i,j)$, $n(i,j)$ $(i\neq j)$ for every small matrix in the non-diagonal position of the coefficient matrix, and limiting the processing of the small matrix in the non-diagonal position of the coefficient matrix to the non-zero elements, the similar effect is achieved.

The comparing result of the simulation result in the present invention and simulation result in the conventional simulation method will be shown below. First, the following conditions are used as the initial setting for simulation.

The number of mesh points as the simulation region obtained through division: 1,183
The number of unknown values which should be determined by solving the equations set in each of the mesh points: 143,569
The number of small matrixes containing non-zero elements, of a plurality of small matrixes of the coefficient matrix corresponding to the equations: 7,649

When the coefficient matrix is processed in accordance with an algorithm in the conventional example in which the matrix shown in Fig. 1 is not reduced in size, a summation of the numbers of elements which are contained in each small matrix of the coefficient matrix is determined as follows.

The number of elements contained in the small matrixes containing non-zero elements: 1,400,024.
The number of elements contained in the small matrixes which occupies diagonal position of the coefficient matrix: 209,140.
The number of elements contained in the small matrixes which occupies non-diagonal position of the coefficient matrix: 1,190,884.

Also, in the above-mentioned initial condition, when the coefficient matrix is processed in accordance with the algorithm in the present invention which the matrix shown in Fig. 4 is reduced in size, a summation of the numbers of elements contained in each small matrix of a coefficient matrix is determined as follows.

The number of elements contained in the small matrixes of non-zero cells: 488,459.
The number of elements contained in the small matrixes which occupy diagonal position of the coefficient matrix: 209,140.
The number of elements contained in the small matrixes which occupy non-diagonal position of the coefficient matrix: 279,319.

From the above-mentioned result, the number of elements contained in the small matrixes in the diagonal position of the coefficient matrix does not change. However, the number of elements contained in the small matrixes in the non-diagonal position of the coefficient matrix is reduced to 1/4 in the algorithm of the present invention, compared with the conventional algorithm. Also, it could be understood that the number of elements over the whole small matrixes is decreased to about 1/3.

Therefore, it could be understood that the number of elements in the small matrix in the non-diagonal position of the coefficient matrix is reduced compared with the case that the algorithm in the conventional example is used. The memory region used to store the elements of the matrix can be reduced to about 1/3 from the above-mentioned result.

Next, a numerical calculation is carried out using the above-mentioned algorithm and the solution of unknown values can be determined. In this numerical calculation, the repetition calculation was carried out until a residual norm became equal to or less than $10^{-7}$. Also, the SGI workstation (MIPS R4400 200MHz) was used for this numerical calculation. The repetition calculation number of times and the total CPU time which are necessary to execute this numerical calculation will be shown below.

First, according to the algorithm in the conventional example, the number of times of the repetition calculation is 17, and the CPU time is 27.7 seconds. Next, according to the algorithm in the present invention, the number of times of the repetition calculation is 17 and the CPU time is 11.0 seconds. Therefore, in this embodiment, the CPU time required can be reduced to about 1/3.

The reason why the result shown in the above is achieved is that in the algorithm of the present invention, the effective elements of the small matrixes in the non-diagonal position of the coefficient matrix are arranged in the compression at the upper left section, and the matrix calculation using the compressed small matrixes is executed so that it is possible to omit the calculation on the zero elements of the small matrixes. With change of the condition to be used such as the parameter, the initial value and so on, processing speeding-up and the reduction effect in the memory region can change.

Moreover, a threshold $\varepsilon$ is provided for each element of the non-diagonal cell. When the partial matrix element which is shown by $\|LD^{-1}\|_2$ and $\|D^{-1}U\|_2$ is smaller than the threshold $\varepsilon$, if the partial matrix element of the corresponding $LD^{-1}$ or $D^{-1}U$ is replaced with the zero element for carrying out the calculation, it is possible to further reduce the CPU time.

It is possible to increase the processing speed for the simulation as the first effect of the present invention.

It is possible to reduce the memory region to be used for the simulation as the second effect of the present invention.

The reason why these effects are achieved is that the effective elements of the small matrixes in the non-diagonal position of the coefficient matrix are arranged in the compression at the upper left section. With change of the condition to be used such as of the parameter, the initial values and so on, the processing speed and the reduction effect in the memory region can change.

**Claims**

1.  A simulation method comprising the steps of:

    setting a matrix corresponding to equations defining physical and/or chemical phenomena in each of mesh regions;
    executing preconditioning to each of a plurality of small matrixes of a coefficient matrix of said matrix, said preconditioning being determined based on influence of each of said equations to other mesh regions; and
    carrying out calculation to said matrix to determine a solution.

2.  A simulation method according to claim 1, wherein each of said equations is a diffusion and/or reaction equation.

3.  A simulation method according to claim 1 or 2, wherein each of said plurality of small matrix has a square matrix which has elements for the number of said equations in row and column directions.

4. A simulation method according to any one of claims 1 to 3, wherein said executing includes:

rearranging said coefficients for said equations which have terms influencing other mesh regions from an upper left portion of said small matrix, and said coefficients for said equations which have only terms not influencing the other meshes in a lower right portion of said small matrix.

5. A simulation method according to any one of claims 1 to 3, wherein said executing includes:

rearranging coefficients of each of said plurality of small matrixes based on said influence of each of said equations to other mesh regions to produce rearranged small matrixes; and
executing incomplete LDU decomposition to said rearranged small matrixes to reduce the number of elements in the small matrix in a non-diagonal position of the coefficient matrix less than an original number of elements.

6. A simulation method according to claim 5, wherein said rearranging includes:

rearranging said coefficients for said equations which has terms influencing other mesh regions diagonally from an upper left portion of said small matrix, and said coefficients for said equations which has only terms not influencing the other meshes in a lower right portion of said small matrix.

7. A simulation method according to claim 5, further comprising:

determining whether said coefficient of a non-diagonal element of said small matrix is smaller than a predetermined value; and
setting zero in place of said coefficient when it is determined that said coefficient of said non-diagonal element of said small matrix is smaller than a predetermined value.

8. A diffusion simulation method, comprising:

dividing a region into meshes;
setting equations defining physical and/or chemical phenomena to each of said meshes;
dividing said equations into a first group which has terms influencing other meshes and a second group which has only terms not influencing the other meshes;
setting a matrix for getting a solution of said equations;
dividing a coefficient matrix contained in said matrix into a plurality of small matrixes, wherein each of said plurality of small matrixes has a size determined based on the number of said equations;
arranging in units of the meshes, coefficients of said equations, which belongs to said first group, in an upper portion of a corresponding small matrix, and coefficients of said equations which belongs to said second group in a lower portion of the corresponding said small matrix;
carrying out calculation to each of said plurality of small matrixes to solve said equations; and
outputting said solution of said equations to an output unit,
wherein said calculation to said small matrixes as non-diagonal elements of said coefficient matrix is carried out to only said coefficients of said equations which belongs to said first group.

9. A diffusion simulation method according to claim 8, wherein said small matrix is a (k-th) order square matrix, when the number of said equations is k.

10. A diffusion simulation method according to claim 8 or 9, further comprising:

reducing said small matrixes as non-diagonal elements to said coefficient matrix to small matrixes which consist of only the coefficients which are related with the equations which belong to said first group.

11. A diffusion simulation method according to any of claims 8 to 10, wherein said region is a semiconductor, and said equations are based on diffusion and/or chemical reaction of at least one of impurity ions, point-defects, holes, electrons, and pairs of said impurity ion and said point-defect in the semiconductor.

12. A computer-readable recording medium which stores a program for a diffusion simulation method, comprising:

dividing a region into meshes;

setting equations defining physical and/or chemical phenomena to each of said meshes;

dividing said equations into a first group which has terms influencing other meshes and a second group which has only terms not influencing the other meshes;

setting a matrix for getting a solution of said equations;

dividing a coefficient matrix contained in said matrix into a plurality of small matrixes, wherein each of said plurality of small matrixes has a size determined based on the number of said equations;

arranging in units of the meshes, coefficients of said equations, which belongs to said first group, in an upper left portion of a corresponding small matrix, and coefficients of said equations which belongs to said second group in a lower right portion of the corresponding said small matrix;

carrying out calculation to each of said plurality of small matrixes to solve said equations; and

outputting said solution of said equations to an output unit,

wherein said calculation to said small matrixes as non-diagonal elements of said coefficient matrix is carried out to only said coefficients of said equations which belongs to said first group.

13. A computer-readable recording medium according to claim 12, wherein said small matrix is a (k-th) order square matrix, when the number of said equations is k.

14. A computer-readable recording medium according to claim 12 or 13, wherein said diffusion simulation method further comprises:

reducing said small matrixes as non-diagonal elements to said coefficient matrix to small matrixes which consist of only the coefficients which are related with the equations which belong to said first group.

15. A computer-readable recording medium according to any one of claim 12 to 14, wherein said region is a semiconductor, and said equations are based on diffusion and/or chemical reaction of at least one of impurity ions, point-defects, holes, electrons, and pairs of said impurity ion and said point-defect in the semiconductor.

# Fig. 1 PRIOR ART

K   I-TH ROW

K   J-TH ROW

I-TH COLUMN          J-TH COLUMN

# Fig. 2

10 PROCESSING SECTION

11 SIMULATION UNIT

17 PARAMETER STORAGE SECTION

| REGION SETTING AND DIVIDING SECTION | ~12 |
| PHENOMENON SETTING SECTION | ~13 |
| MATRIX SETTING SECTION | ~14 |
| ARRANGING SECTION | ~15 |
| CALCULATING SECTION | ~16 |

40

DEVICE

RECORDING MEDIUM

41

20

INPUT UNIT

OUTPUT UNIT

30

# Fig. 3

S201 — DIVIDING TO MESHES

S202 — DEFINE DIFFUSION AND REACTION EQUATION FOR EVERY MESH

S203 — SUBSTITUTE INITIAL VALUES

S204 — DEFINE MATRIX

S205 — RE-ARRANGE EQUATIONS

S206 — PRE-PROCESSING

S207 — CALCULATION

S208 — PREDETERMINED TIME:ELAPSED ?

N → S209 RE-SET COEFFICIENTS

Y

S210 — OUTPUT

# Fig. 4

I-TH ROW

J-TH ROW

I-TH COLUMN          J-TH COLUMN

# Fig. 5

# Fig. 6

# Fig. 7